(19) Europäisches Patentamt

European Patent Office

Office européen des brevets

(11) **EP 1 737 126 A1**

(12) **EUROPEAN PATENT APPLICATION**
published in accordance with Art. 158(3) EPC

(43) Date of publication:
**27.12.2006 Bulletin 2006/52**

(51) Int Cl.:
*H03H 9/64* (2006.01)    *H01L 41/09* (2006.01)
*H01L 41/18* (2006.01)    *H03H 9/145* (2006.01)

(21) Application number: **05730365.3**

(22) Date of filing: **12.04.2005**

(86) International application number:
**PCT/JP2005/007089**

(87) International publication number:
**WO 2005/101657 (27.10.2005 Gazette 2005/43)**

(84) Designated Contracting States:
**DE FR**

(30) Priority: **16.04.2004 JP 2004121969**

(71) Applicant: **Toyo Communication Equipment Co., Ltd.**
**Kawasaki-Shi,**
**Kanagawa 212-8513 (JP)**

(72) Inventor: **MATSUMOTO, S.;**
**c/o Toyo Com. Equipment Co. Ltd**
**Kouza-gun, Kanagawa 2530192 (JP)**

(74) Representative: **GROSSE BOCKHORNI**
**SCHUMACHER**
**Patent- und Rechtsanwälte**
**Forstenrieder Allee 59**
**81476 München (DE)**

(54) **BALANCED TYPE SURFACE ACOUSTIC WAVE FILTER**

(57)    To provide means for improving a guaranteed attenuation of a cascade-connected unbalanced-balanced double-mode SAW filter. An unbalanced-balanced SAW filter is configured by providing two cascade-coupled primary-tertiary double-mode SAW filters on a piezoelectric substrate along a propagation direction of a surface wave in parallel and cascade-connecting them, connecting one of electrodes of an IDT of a first double-mode SAW filter disposed at a central portion to a first port Port1, and connecting one of electrodes of an IDT of a second double-mode SAW filter disposed at a central portion to a second port Port2, and connecting the other electrode thereof to a third port Port3. The SAW filter is configured by disposing an electrode near the surroundings of the first port Port1 and the third port Port3 and connecting the electrode to a lead electrode provided at a peripheral edge of the piezoelectric substrate.

[Fig.1]

EP 1 737 126 A1

**Description**

TECHNICAL FIELD

The present invention relates to a balanced surface acoustic wave filter, and more particularly to a balanced surface acoustic wave filter with an improved guaranteed attenuation.

BACKGROUND ART

In recent years, since a surface acoustic wave filter (hereinafter, "SAW filter") has excellent features such as high performance, small size, and mass productivity, it is frequently used in a portable phone or the like. In a recent portable phone, a digital circuit and an analog circuit are housed in a very small space. Therefore, it is important to reduce noise generated by each of the digital circuit and the analog circuit and also to avoid noise from the other circuit as much as possible. In order to reduce generated noise and to avoid influence of noise from the other circuit, it is required to balance input and output circuits of an RF circuit and an IF circuit, and accordingly, devices used in the RF and IF circuits and the like need to be of a balanced type.

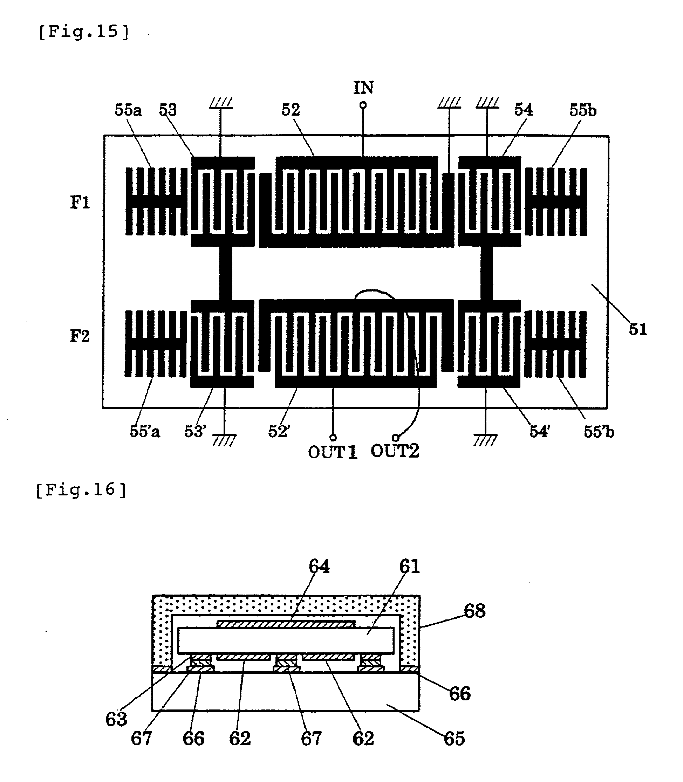

Fig. 15 is a diagram showing a configuration of a cascade-coupled primary-tertiary double-mode SAW filter of a two-stage cascade-connected type used in the RF circuit. In a configuration example, a side (IN) to be connected to an antenna is an unbalanced circuit while a side (OUT1-OUT2) to be connected to an IC circuit is a balanced circuit. Interdigital transducers (IDT) 52, 53, 54 are arranged in proximity on a principal surface of a piezoelectric substrate 51 along a propagation direction of a surface wave, and grating reflectors (hereinafter, "reflectors") 55a and 55b are arranged on both sides of the IDTs 52, 53, 54. The IDTs 52, 53, 54 and the reflectors 55a and 55b form a first double-mode SAW filter F1. The first double-mode SAW filter F1 is a cascade-coupled primary-tertiary double-mode SAW filter. Similarly, a second double-mode SAW filter F2 that is a cascade-coupled primary-tertiary double-mode SAW filter includes IDTs 52', 53', 54' and reflectors 55'a and 55'b. A two-stage cascade-connected SAW filter is configured by cascade-connecting the first double-mode SAW filter F1 and the second double-mode SAW filter F2.

In order to set an input side to an unbalanced input, one electrode of the IDT 52 is connected to an input terminal IN, while the other electrode thereof is grounded. On the other hand, in order to set an output side to a balanced output, one electrode of the IDT 52' is connected to an output terminal OUT1, while the other electrode thereof is connected to an output terminal OUT2. The SAW filter is configured by cascade-connecting the cascade-coupled double-mode SAW filters in two-stage so as to increase an attenuation slope and a guaranteed attenuation to satisfy required standards.

However, there is a problem in that a SAW filter configured by accommodating a SAW filter element with such a configuration in a ceramic package does not satisfy strict standards required for recent portable phone RF filters such as a guaranteed attenuation. A SAW filter disclosed in Japanese Patent Application Laid-Open No. 2002-76828 has been invented in order to solve this problem. In this SAW filter, as shown in Fig. 16, a SAW filter element is configured by forming IDTs 62 and pad electrodes 63 on a piezoelectric substrate 61 and forming a conductive electrode 64 on an opposite side of the piezoelectric substrate 61 so as to face the IDTs 62. The SAW filter is configured by connecting the pad electrodes 63 of the SAW filter element and terminal electrodes 66 formed on a ceramic substrate 65 via metal bumps 67 to make them conductive and sealing the SAW filter element using a metal case 68.

Japanese Patent Application Laid-Open No. 2002-76828 describes that the reason why the guaranteed attenuation is improved by the configuration is that, since the conductive electrode 64 is formed to face the IDTs 62, floating capacitance is formed between the IDTs 62 and the conductive electrode 64 and the attenuation is improved by the floating capacitance.

However, there are problems in that, since the conductive electrode 64 is formed on a back face of the piezoelectric substrate, the number of manufacturing steps increases and the metal case 68 that is a sealing material is expensive, that it is necessary to provide a space between the SAW filter element and the metal case 68, which increases the size of the SAW filter, and also that the guaranteed attenuation is fluctuated by a slight positional deviation between the IDTs 62 and the conductive electrode 64.

Japanese Patent No. 3440935 describes about a SAW filter having a balanced-unbalanced converting function. As also described in this conventional art, a magnitude of an attenuation outside a pass band of a surface acoustic wave filter having a balanced-unbalanced converting function largely depends on balance of the surface acoustic wave filter. The balance is expressed by a difference between the transmission characteristic between an unbalanced signal terminal and a first balanced signal terminal and the transmission characteristic between the unbalanced signal terminal and a second balanced signal terminal. A difference between the amplitude characteristics of the transmission characteristics is called "amplitude balance" and a difference between the phase characteristics is called "phase balance".

Assuming that the surface acoustic wave filter having the balanced-unbalanced converting function is a device having first to third ports, for example, when an unbalanced input terminal is defined as a first port and respective ports of first and second balanced output terminals are defined as a second port and a third port, the amplitude balance and the phase balance are expressed by the following equations:

$$\text{Amplitude balance}=|A| \qquad A=\left||20\log(S21)|-|20\log(S31)|\right|$$

$$\text{Phase balance}=|B-180| \qquad B=|\angle S21-\angle 31|$$

In a conventional balanced-unbalanced SAW filter, since the first balanced signal terminal and the second balanced signal terminal are different in the way of addition of parasitic impedance, the balance outside a pass band deteriorates. Therefore, according to the invention described in Japanese Patent No. 3440935, an electrode is configured such that the parasitic impedance is approximately equally added in the first balanced signal terminal and the second balanced signal terminal.

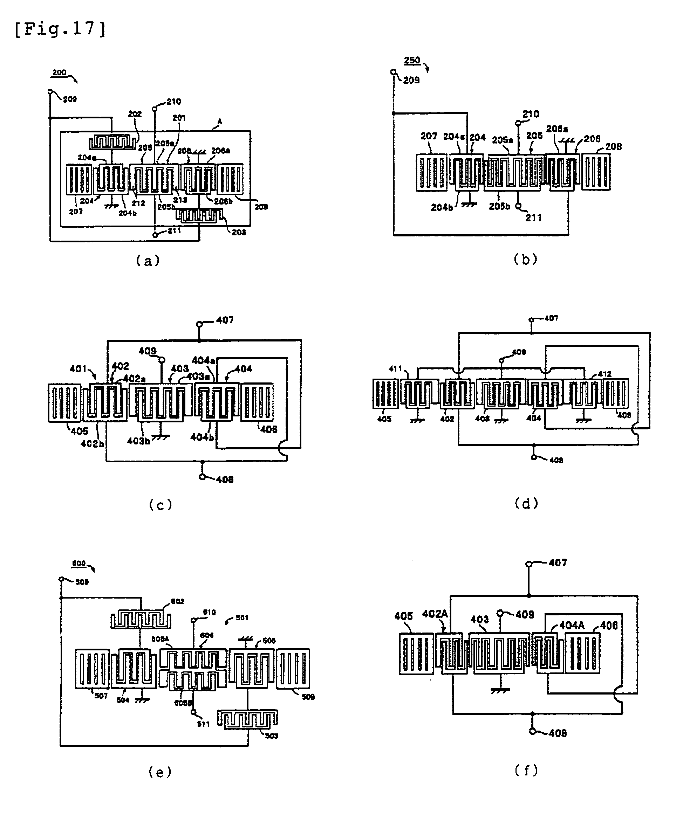

Specifically, as shown in Figs. 17(a) to 17(f), first and third IDTs are arranged at point symmetry about a second IDT so that the parasitic impedances added to the first and the second balanced signal terminals are equal to each other.

Patent Document 1: Japanese Patent Application Laid-Open No. 2002-76828

Patent Document 2: Japanese Patent No. 3440935

DISCLOSURE OF THE INVENTION

PROBLEMS TO BE SOLVED BY THIS INVENTION

However, although parasitic impedances added to the first balanced signal terminal and the second balanced signal terminal are made approximately equal by arranging a first IDT and a third IDT at point symmetry about a second IDT in the invention disclosed in Japanese Patent No. 3440935, for example, when a configuration in which double-mode SAW filters are cascade-connected in two stages is adopted in order to achieve a desired guaranteed attenuation, there is a problem in that flexibility of arrangement of each IDT or wiring between the IDTs becomes extremely limited.

MEANS FOR SOLVING THE PROBLEM

In order to improve the guaranteed attenuation, therefore, the invention of claim 1 provides a balanced surface acoustic wave filter in which an input side formed on a piezoelectric substrate is made to be unbalanced and an output side formed thereon is made to be balanced, wherein an output pad electrode disposed farther away from an input pad electrode disposed on the piezoelectric substrate is coupled via a bridging capacitor.

The invention of claim 2 provides a balanced surface acoustic wave filter of a cascade-coupled double-mode in which three interdigital transducers are arranged in proximity on a piezoelectric substrate along a propagation direction of a surface acoustic wave and reflectors are arranged on both sides of the interdigital transducers, and an input side is made to be unbalanced and an output side is made to be balanced, wherein an output pad electrode disposed farther away from an input pad electrode disposed on the piezoelectric substrate is coupled via a bridging capacitor.

The invention of claim 3 provides a balanced surface acoustic wave filter in which two cascade-coupled double-mode surface acoustic wave filters having a configuration where three interdigital transducers are arranged in proximity on a piezoelectric substrate along a propagation direction of a surface acoustic wave and reflectors are arranged on both sides of the interdigital transducers are cascade-connected, and an input side is made to be unbalanced and an output side is made to be balanced, wherein an output pad electrode disposed farther away from an input pad electrode disposed on the piezoelectric substrate is coupled via a bridging capacitor.

The invention of claim 4 provides a balanced acoustic wave filter in which cascade-coupled double-mode surface acoustic wave filters having a configuration where three interdigital transducers are arranged in proximity on a piezoelectric substrate along a propagation direction of a surface acoustic wave and reflectors are arranged on both sides of the interdigital transducers are arranged in parallel through a predetermined space, electrodes of the interdigital transducers of the cascade-coupled double-mode surface acoustic wave filters disposed at both outsides, the electrodes being disposed at the side of the space, are connected to each other and outside electrodes thereof are connected to ground pad electrodes, an electrode of the interdigital transducer of one of the cascade-coupled double-mode surface acoustic wave filters disposed at a central portion, the electrode being disposed at the side of the space, is connected to a ground pad electrode and an outside electrode thereof is connected to an input pad electrode, and an electrode of the interdigital transducer of the other of the cascade-coupled double-mode surface acoustic wave filters disposed at a central portion, the electrode being disposed at the side of the space, is connected to a first output pad electrode and an outside electrode thereof is connected to a second output pad electrode, where an input side is made to be unbalanced and an output side is made to be balanced, wherein the input pad electrode and the second output pad electrode are coupled to each other via a bridging capacitor disposed on the piezoelectric substrate.

The invention of claim 5 provides the balanced surface acoustic wave filter of claim 4, wherein a lead electrode connecting the bridging capacitor is provided on a peripheral edge of the piezoelectric substrate.

The invention of claim 6 provides the balanced surface acoustic wave filter of claim 4, wherein a lead electrode connecting the bridging capacitor is provided on one peripheral edge of the piezoelectric substrate.

The invention of claim 7 provides the balanced surface acoustic wave filter of claim 4, wherein the capacitor is configured by arranging a lead electrode from the input pad electrode to a central portion of the piezoelectric substrate along a peripheral edge of the piezoelectric substrate and arranging a lead electrode from the second output pad electrode to the central portion of the piezoelectric substrate along the peripheral edge of the piezoelectric substrate.

The invention of claim 8 provides a balanced surface acoustic wave filter in which a cascade-coupled double-mode surface acoustic wave filter is configured by arranging three interdigital transducers on a piezoelectric substrate in proximity along a propagation direction of a surface acoustic wave and arranging reflectors on both sides of the interdigital transducers, respective ones of electrodes of the interdigital transducers of the cascade-coupled double-mode surface acoustic wave filter arranged at both outsides thereof are connected to input pad electrodes, and the other electrodes thereof are grounded, respectively, and one of electrodes of the interdigital transducer arranged at a central portion thereof is connected to a first output pad electrode and the other electrode thereof is connected to a second output pad electrode, where an input side is made to be unbalanced and an output side is made to be balanced, wherein the input pad electrode and the second output pad electrode are coupled to each other via a bridging capacitor disposed on the piezoelectric substrate.

The invention of claim 9 provides the balanced surface acoustic wave filter of claim 8, configured by arranging a first electrode near the surroundings of the second output pad electrode, providing a second electrode near a lead electrode connecting the input pad electrode and one of the interdigital transducers of the cascade-coupled double-mode surface acoustic wave filter disposed outside, and connecting the first and the second electrodes through a lead electrode.

EFFECT OF THE INVENTION

In the balanced surface acoustic wave filter (balanced SAW filter) according to the present invention, since electrodes are formed near the surroundings of the input pad electrode (input port) and the output pad electrode (output port), a bridging capacitor is formed by the electrode and the lead electrode between input and output, so that a guaranteed attenuation of the SAW filter can be improved.

Since the bridging capacitor is formed by the electrode and the lead electrode, it is unnecessary to provide an expensive metal case or a space between the SAW filter element and the metal case. Accordingly, the SAW filter can be accommodated even in a CSP (Chip Sized Package) by resin sealing.

Since the bridging capacitor is formed by the electrode and the lead electrode and a phase balance can be maintained ideally, even when a plurality of IDTs are arranged on the same substrate such that double-mode SAW filters are cascade-connected in a multi-stage, the flexibility of arrangement of the IDTs or wiring among them can be ensured.

BEST MODE FOR CARRYING OUT THE INVENTION

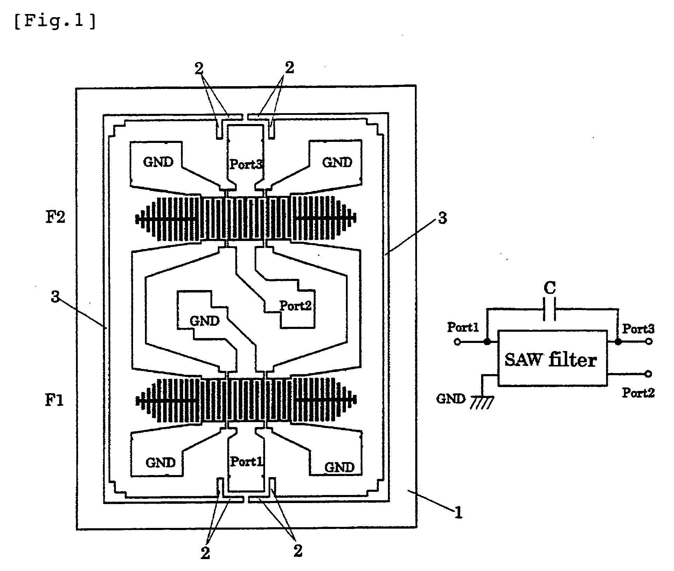

The present invention will be explained in detail below while showing exemplary embodiments of the invention. Fig. 1 is a detailed plan view showing an embodiment of a balanced double-mode SAW filter according to the present invention.

A first double-mode SAW filter F1 is configured by arranging three interdigital transducers (IDT) on a piezoelectric substrate 1 along a propagation direction of a surface wave and arranging grating reflectors outside the IDTs positioned on both ends. A second double-mode SAW filter F2 is also configured similarly to the first double-mode SAW filter. The first double-mode SAW filter F1 and the second double-mode SAW filter F2 are cascade-connected.

Respective ones of electrodes of the IDTs of the first double-mode SAW filter F1 positioned at both outsides are grounded (GND), and one of electrodes of the IDT of the first double-mode SAW filter F1 disposed at a central portion is connected to a first port Port1 that is an input pad electrode. The other electrode of the IDT disposed at the central portion is grounded (GND).

Respective ones of electrodes of the IDTs of the second double-mode SAW filter F2 positioned at both outsides are grounded. One of electrodes of the IDT disposed at a central portion is connected to a second port Port2 that is an output pad electrode and the other electrode thereof is connected to a third port Port3 that is an output pad electrode. Thus, a SAW filter including an unbalanced-balanced function is configured.

Electrodes 2 for capacitor formation are arranged near the surroundings of the first port Port1 and the third port Port3 and the electrodes 2 are connected to one another via lead electrodes 3 formed at a peripheral edge of the piezoelectric substrate 1.

By arranging the electrodes 2 near the surroundings of the first port Port1 and the third port Port3 and connecting the electrodes 2 via the lead electrodes 3 formed at the peripheral edge of the piezoelectric substrate 1, a bridging capacitor C is formed between the first port Port1 and the third port Port3, as shown on the right side in Fig. 1. Capacitance of the capacitor C mainly depends on a size of the electrode 2, a gap between the electrode 2 and the first port Port1 and a gap between the electrode 2 and the third port Port3.

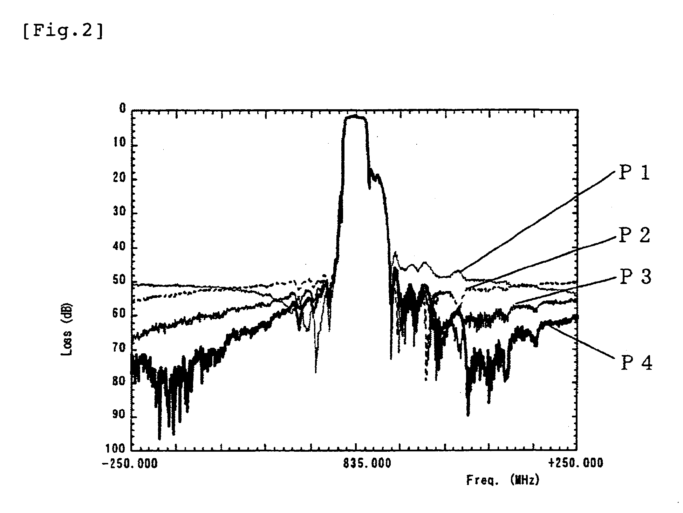

A result obtained by measuring the filter characteristics of a double-mode SAW filter of a two-stage cascade-connection shown in Fig. 1 manufactured experimentally while changing the size of the electrodes 2 and the gap therebetween is shown in Fig. 2.

The obtained filter is a SAW filter for an RF filter of 800MHz band W-CDMA system where 38.7° Y-XLiTaO$_3$ is used for a piezoelectric substrate, the number of pairs of the IDT positioned at the central portion is 29, the number of pairs of each of the IDTs positioned at the both sides are 19.5, a crossing width is 30λ (λ represents a wavelength), and the number of reflectors is 95.

The filter characteristic shown by P1 in Fig. 2 is the characteristic of a so-called conventional SAW filter in which the electrodes 2 for capacitor formation is not provided, and the filter characteristics shown by P2, P3, and P4 are the filter characteristics obtained when capacitance of the bridging capacitor C is changed by respectively changing the size of the electrodes 2 and the gap.

The filter characteristic shown by P2 corresponds to a case in which a configuration of the electrode 2 with respect to the third port Port3 as shown in Fig. 3(c) has been adopted, the filter characteristic shown by P3 corresponds to a case in which a configuration of the electrode 2 with respect to the third port Port3 as shown in Fig. 4(c) has been adopted, and the filter characteristic shown by P4 corresponds to a case in which a configuration of the electrode 2 with respect to the third port Port3 as shown in Fig. 5(c) has been adopted. Although positions and sizes of the third port Port3 and the electrode 2 are shown in the respective drawings, a relationship between the electrode 2 and the first port Port1, and a relationship between the electrode 2 and the third port Port3 are also similar to the above relationship.

As shown in Fig. 2, the characteristics P2, P3, and P4 of the SAW filter where the bridging capacitor is formed between the first port Port1 and the third port Port3 using the electrodes 2 do not change in a pass band characteristic as compared with the characteristic P1 of the conventional SAW filter that does not include the electrodes 2 for capacitor formation and they are largely different only in attenuation characteristics from the characteristic P1. That is, a desired characteristic can be obtained by selecting a bridging capacitor appropriately according to a required specification.

An attenuation characteristic of a balanced side output OUT1-OUT2 of the SAW filter largely depends on balances, where an amplitude balance and a phase balance are both represented by a difference between the transmission characteristics S21 and S31. Accordingly, the amplitude characteristics and the phase characteristics of the transmission characteristics S21 and S31 are measured and compared.

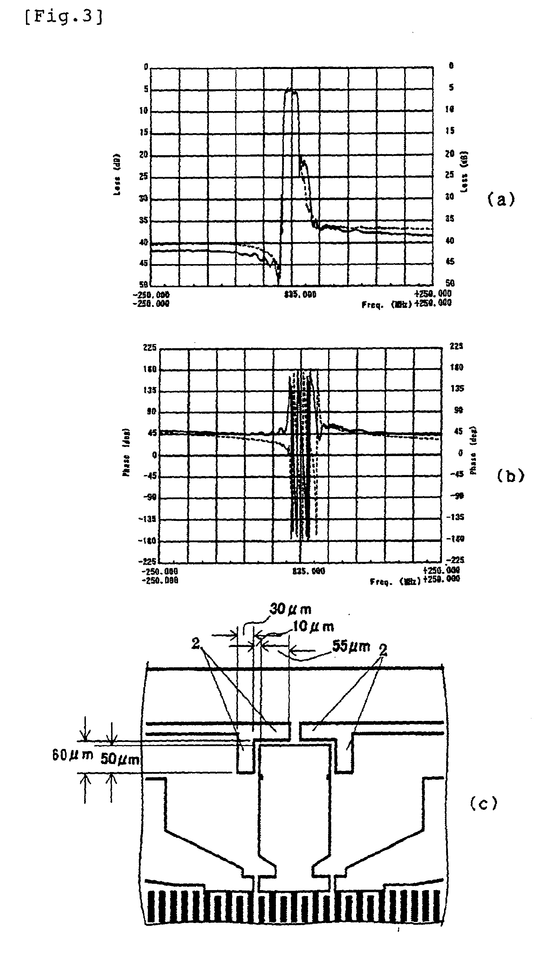

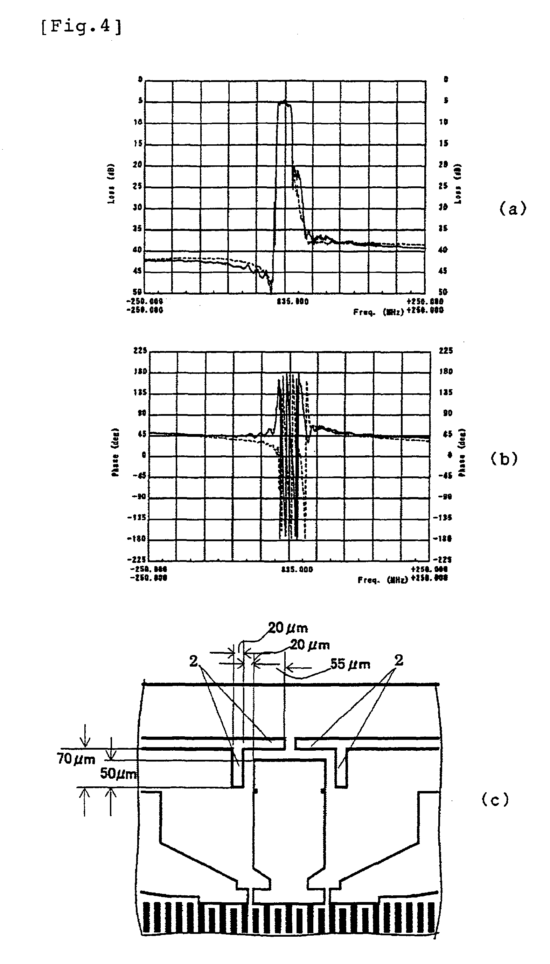

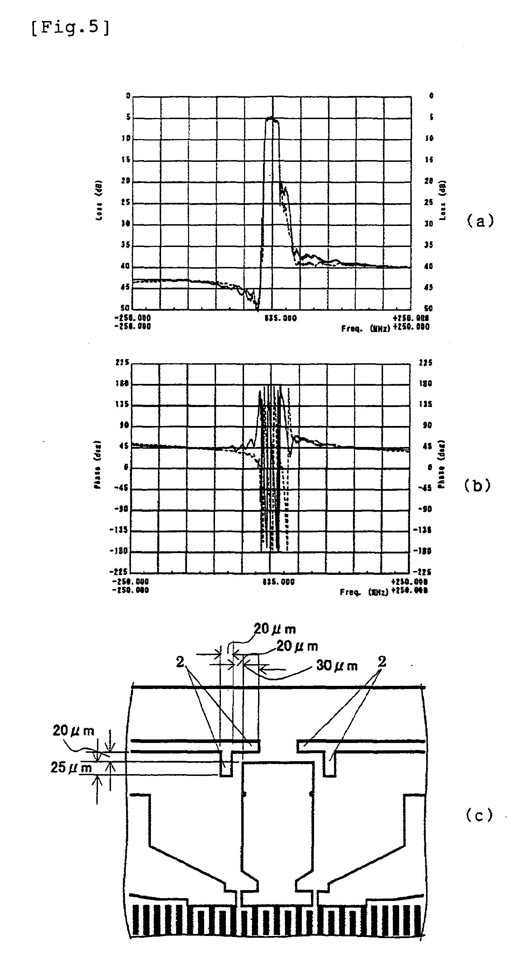

Figs. 3(a) and 3(b) are diagrams showing the amplitude characteristic and the phase characteristic obtained when the electrode 2 has been formed as shown in Fig. 3(c), Figs. 4(a) and 4(b) are diagrams showing the amplitude characteristic and the phase characteristic obtained when the electrodes 2 have been formed as shown in Fig. 4(c), and Figs. 5(a) and 5(b) are diagrams showing the amplitude characteristic and the phase characteristic obtained when the electrodes 2 have been formed as shown in Fig. 5(c). In each characteristic diagram, a solid line shows a characteristic of the transmission characteristic S21 and a broken line shows a characteristic of the transmission characteristic S31.

When the amplitude characteristics of the transmission characteristics S21 and S31 shown in Fig. 3(a) and the amplitude characteristics of the transmission characteristics S21 and S31 shown in Fig. 5(a) are compared with each other, the amplitude characteristics shown in Fig. 5(a) are smaller in the difference in the amplitude characteristic between the transmission characteristics S21 and S31. Similarly, when the phase characteristics of the transmission characteristics S21 and S31 shown in Fig. 3(b) and the phase characteristics of the transmission characteristics S21 and S31 shown in Fig. 5(b) are compared with each other, the phase characteristics shown in Fig. 5(b) are smaller in the difference in the phase characteristic between the transmission characteristics S21 and S31. As shown in Fig. 2, when the filter characteristics P2 and P4 are compared with each other, the attenuation characteristic of the filter characteristics P4 (a filter having a configuration shown in Fig. 5) is larger than that of the filter characteristics P2.

As understood from these drawings, therefore, since an attenuation of balanced output becomes larger in a frequency band near the pass band according to reduction of the differences between the amplitude characteristics and between the phase characteristics of the transmission characteristics S21 and S31, which is obtained by changing the bridging capacitor, the attenuation characteristic can be improved in a desired frequency band near the pass band by appropriately setting a value of the bridging capacitor C.

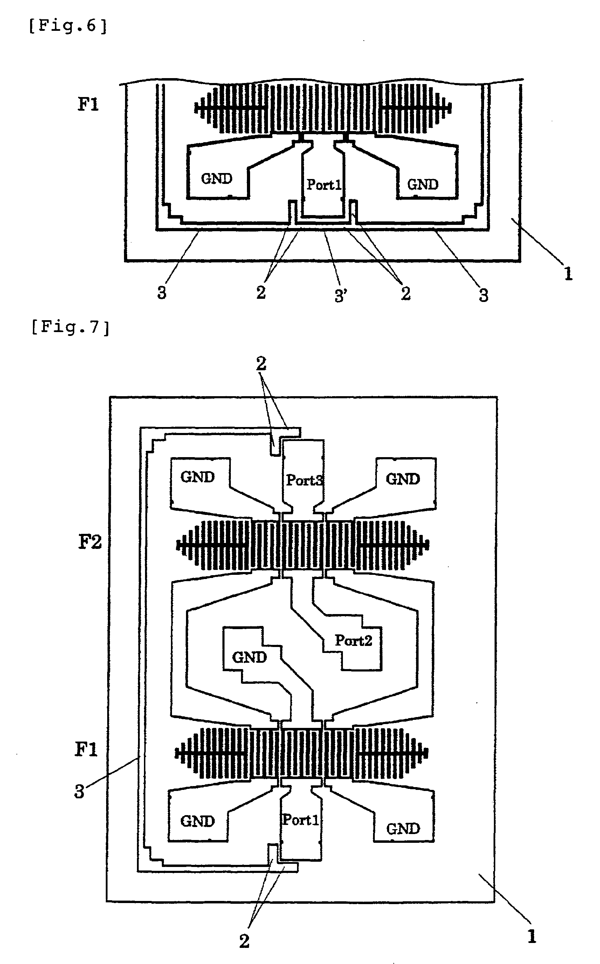

Fig. 6 is a diagram showing a balanced double-mode SAW filter of a second embodiment according to the present invention. The second embodiment is different from the first embodiment shown in Fig. 1 in that the electrodes 2 for capacitor formation have been short-circuited by a lead electrode 3'. Since the bridging capacitor C is connected between the first port Port1 and the third port Port3 also in this configuration, the guaranteed attenuation can be improved by appropriately setting the capacitor C. Although the drawing shows only a part of the first double-mode SAW filter F1 of the balanced double-mode SAW filter in enlargement, the configuration of the third port Port3 and the electrodes 2 in the second double-mode SAW filter F2 may be similar to the illustrated configuration such that the electrodes 2 for capacitor formation may also be short-circuited by the lead electrode 3'.

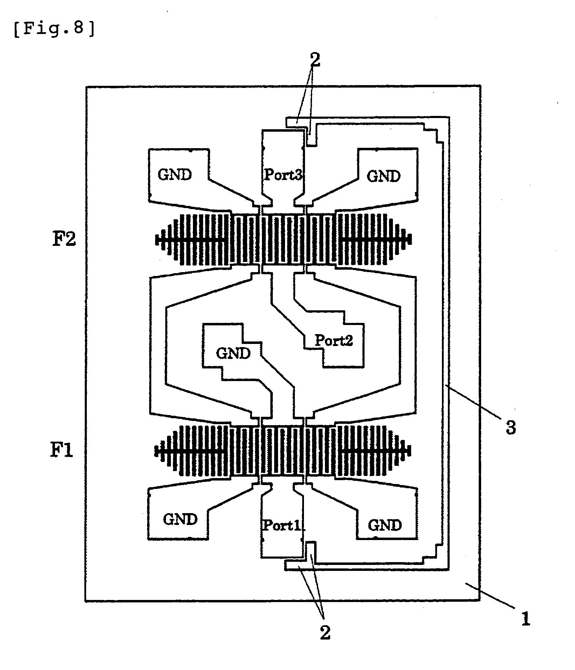

Figs. 7 and 8 are plan views showing third and fourth embodiments. A difference in configuration of the third and the fourth embodiments from the first embodiment shown in Fig. 1 lies in that the electrodes 2 for capacitor formation and the lead electrode 3 connecting the electrodes 2 are provided on a left half or a right half of the drawings. By appropriately setting the size of the electrodes 2, the gap between the first port Port1 and the electrode 2 and the gap between the third port Port3 and the electrode 2 also in these configurations, the bridging capacitor C is formed between the first port Port1 and the third port Port3 so that the guaranteed attenuation can be improved.

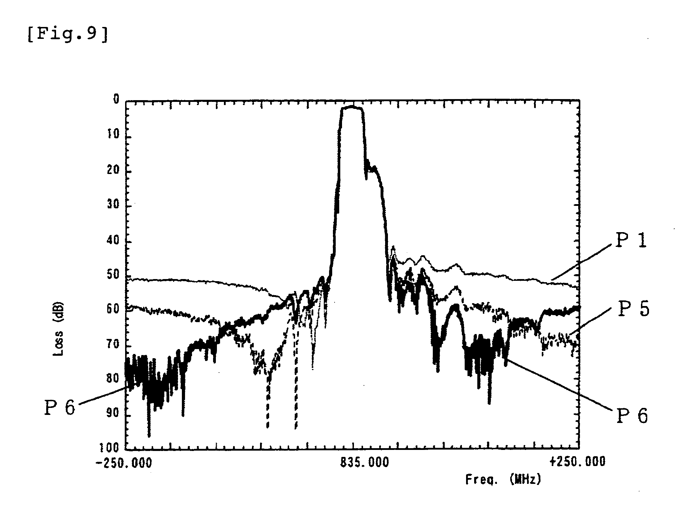

Fig. 9 is a diagram in which the filter characteristics of SAW filters manufactured experimentally using the electrode patterns shown in Figs. 7 and 8 have been overwritten, where the same parameters as those shown in Fig. 2 are used for a piezoelectric substrate, IDTs, reflectors, and the like. The filter characteristic of the SAW filter adopting the electrode pattern shown in Fig. 7 is shown by P5, and the filter characteristic of the SAW filter adopting the electrode pattern shown in Fig. 8 is shown by P6. The filter characteristic P1 is shown for comparison with the filter characteristics P5 and P6, and it is a filter characteristic obtained when the configuration shown in Fig. 2 is adopted.

As apparent from the drawing, even if the electrode pattern shown in Fig. 7 or Fig. 8 is used, the guaranteed attenuation in a desired frequency band of the SAW filter can be improved by appropriately setting the sizes of the electrodes 2 for capacitor formation, the gap between the electrode 2 and the first port Port1 and the gap between the electrode 2 and the third port Port3.

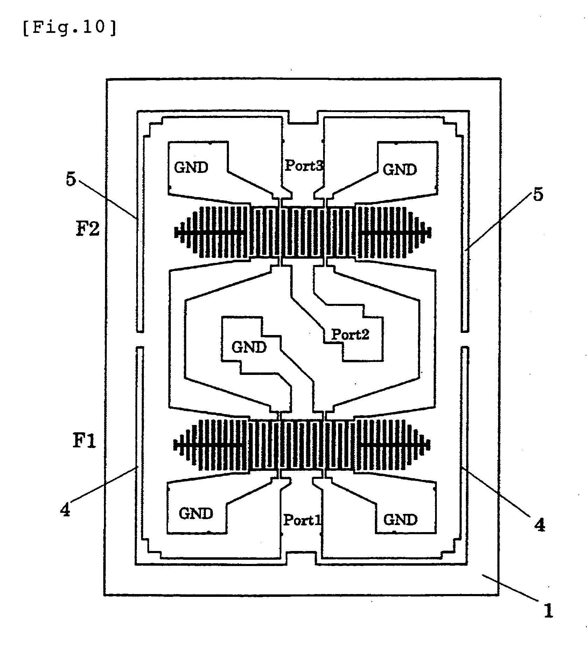

Fig. 10 is a diagram showing a balanced double-mode SAW filter of a fifth embodiment according to the present invention. A difference of the fifth embodiment from the first embodiment lies in that, instead of the electrodes 2, a lead electrode 4 is formed to extend from the first port Port1 to a central portion of the piezoelectric substrate 1 along a peripheral edge of the piezoelectric substrate 1 and a lead electrode 5 is formed to extend from the third port Port3 to the central portion of the piezoelectric substrate 1 along the peripheral edge of the piezoelectric substrate 1. The bridging capacitor C is formed between the lead electrode 4 and the lead electrode 5 instead of the electrodes 2.

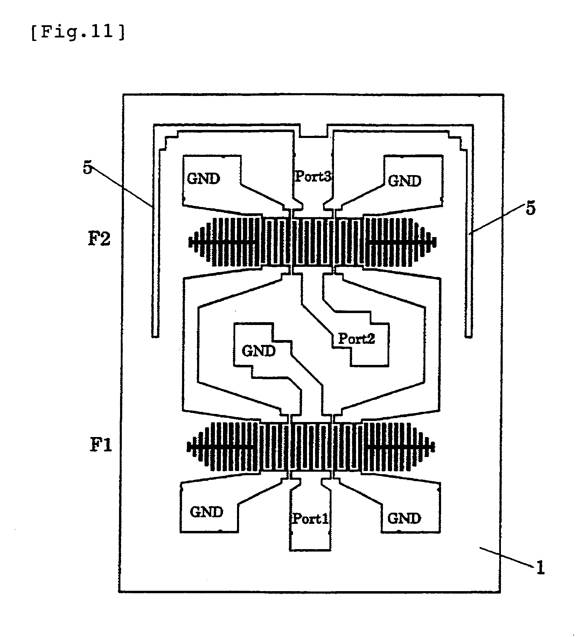

Fig. 11 is a diagram showing a balanced double-mode SAW filter of a sixth embodiment according to the present invention. A difference of the sixth embodiment from the fifth embodiment lies in that a lead electrode 6 is formed to extend only from the third port Port3 to the central portion of the piezoelectric substrate 1 along the peripheral edge of the piezoelectric substrate 1.

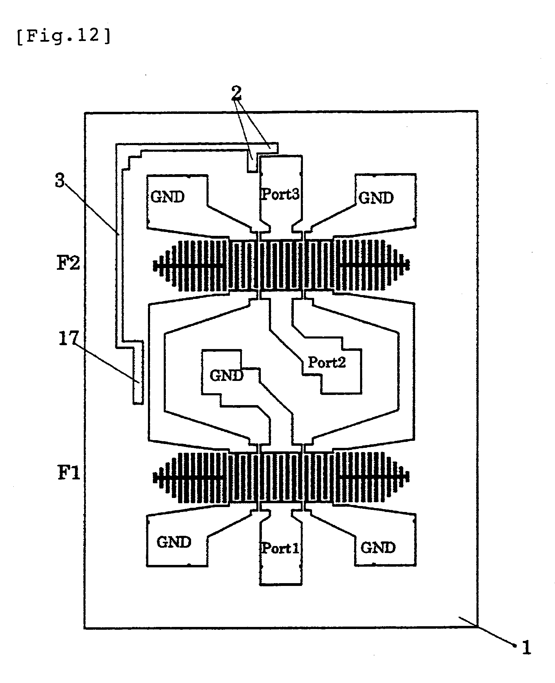

Fig. 12 is a diagram showing a balanced double-mode SAW filter of a seventh embodiment according to the present invention. A difference of the seventh embodiment from the fifth embodiment lies in that the electrodes 2 are disposed at a position near the third port Port3, an electrode 17 is formed near a lead electrode formed for cascade-connection that connects an IDT of the double-mode SAW filter F1 positioned outside and an IDT of the double-mode SAW filter F2 positioned outside, and the electrode 17 and the electrode 2 are connected by the lead electrode 3 formed on a peripheral edge of the piezoelectric substrate 1.

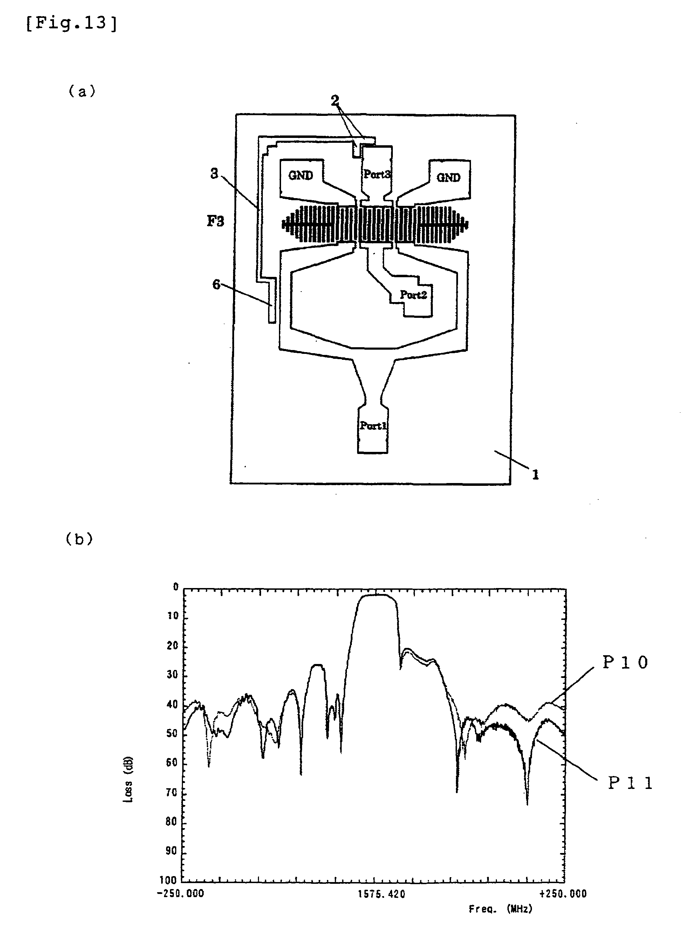

Fig. 13(a) is a diagram showing a balanced double-mode SAW filter of an eighth embodiment according to the present invention. A difference of the eighth embodiment from the seventh embodiment lies in that, instead of the two-stage cascade-connection, only one stage is adopted in the SAW filter.

That is, a double-mode SAW filter F3 is formed by providing three IDTs on the piezoelectric substrate 1 along a propagation direction of a surface wave and further disposing reflectors on both sides of the IDTs. Respective ones of electrodes of the IDTs positioned at both outsides are connected to the first port Port1 via lead electrodes formed on the piezoelectric substrate 1, while the other electrodes thereof are connected to the ground extrode (GND). One of electrodes of the IDT positioned at a central portion is connected to the second port Port2 and the other electrode thereof is connected to the third port Port3. Thus, a double-mode SAW filter of an unbalanced-balanced type is configured.

The electrode 2 for bridging capacitor is formed near the surroundings of the third port Port3, and the electrodes 2 and an electrode 6 are provided, and both the electrodes are connected via the lead electrode 3.

Fig. 13(b) is a diagram in which the filter characteristics of a SAW filter manufactured experimentally using the electrode pattern shown in Fig. 13 (a) are overwritten. The SAW filter is used for a GPS where a center frequency is 1575.42 MHz, and a configuration thereof is such that a 38.7° Y-XLiTaO$_3$ is used for the piezoelectric substrate, the number of pairs of the central IDT is 32, the number of each of the IDTs on both the sides is 22.5, the crossing width is 30λ, and the number of reflectors is 110.

P10 shown in Fig. 13 (b) shows the filter characteristics obtained when an electrode for capacitor formation is not provided in Fig. 13(a), and P11 shows the filter characteristics obtained when the sizes of the electrodes 2 and 6, the gap between the electrode 2 and the first port Port1 and the gap between the electrode 6 and the third port Port3 are set appropriately so that the capacitance of the bridging capacitor becomes 0.03pF. As shown in Fig. 13 (b), by forming the bridging capacitor between the first port Port1 and the third port Port3, the attenuation characteristic increases, so that the guaranteed attenuation in a desired frequency band in the SAW filter can be improved.

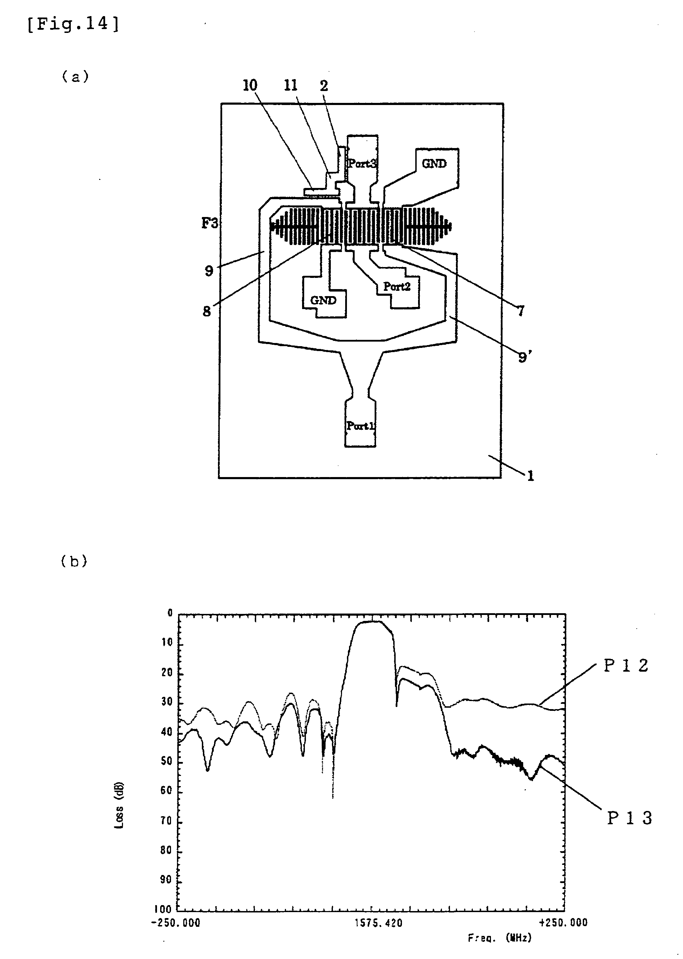

Fig. 14(a) is a diagram showing a balanced double-mode SAW filter of a ninth embodiment according to the present invention. A difference of the ninth embodiment from the eighth embodiment lies in that electrode fingers in an IDT 7 positioned outside are arranged so as to be shifted to an IDT 8 by π. Therefore, an electrode (on a lower side in the drawing) of the IDT 8 near the central portion of the piezoelectric substrate 1 is grounded and an electrode (on an upper side in the drawing) on the other side is connected to the first port Port1 via a lead electrode 9. The electrode 2 is formed near the surroundings of the third port Port3, an electrode 10 is formed further closer to the lead electrode 9, and the electrode 2 and the electrode 10 are connected via a lead electrode 11.

By thus arranging the IDTs on both sides at point symmetry about the central IDT, wiring patterns of the second port Port2 side and the third port Port3 side become approximately symmetrical with each other, so that the balance is improved as compared with the SAW filter with the configuration shown in Fig. 13(a), thereby improving the attenuation outside the pass band. Since the differences in the phase characteristic and in the amplitude characteristic between the transmission characteristics S21 and S31 due to a difference between a distance between the first port Port1 and the second port Port2 and a distance between the first port Port1 and the third port Port3 is compensated for by the bridging capacitor by the electrodes 2, 9, 10, and 11 and the third port Port3, the balance and an attenuation outside a pass band superior to those in Japanese Patent No. 3440935 descried in the conventional art can be obtained.

Fig. 14(b) is a diagram in which the filter characteristics of a SAW filter manufactured experimentally using the electrode pattern shown in Fig. 14(a) have been overwritten, where the same parameters as those shown in Fig. 13 (b) are used for a piezoelectric substrate, IDTs, ref lectors, and the like, and the center frequency is set at 1575.42 MHz. P12 shown in Fig. 14(b) shows the filter characteristics obtained when the electrodes 2, 11, and the like for capacitor formation are not provided, and P13 shows the filter characteristics obtained when the sizes of the electrodes 2 and 10, the gap between the electrodes 2 and the third port Port3 and the gap between the electrode 10 and the lead electrode 9 have been set appropriately such that a capacitance of the bridging capacitor becomes 0.10pF. As shown in Fig. 14(b), by forming the bridging capacitor between the third port Port3 and the lead electrode 9, the attenuation characteristic increases, so that, particularly, the attenuation on a high-pass side of the pass band can be improved largely.

When the SAW filter is used as an RF filter, generally, it is frequently utilized such that a side thereof connected to an antenna is an unbalanced circuit with 50Ω and a side thereof connected to an IC circuit is a balanced circuit with 200Ω, so that it is configured such that an impedance matches with 200Ω by thinning the electrode fingers of the central IDT on the balanced circuit side.

BRIEF DESCRIPTION OF THE DRAWINGS

[Fig. 1] Fig. 1 is a schematic plan view showing a configuration of a first embodiment of a SAW filter according to the present invention.

[Fig. 2] Fig. 2 is a diagram showing the filter characteristics obtained when a capacitance of a bridging capacitor C formed by a first port Port1, a third port Port3, and electrodes 2 is changed according to the first embodiment.

[Fig. 3] Figs. 3 are diagrams showing an aspect of the bridging capacitor in the first embodiment, where Fig. 3(a) being a diagram showing the amplitude characteristics of the transmission characteristics S21 and S31 due to the bridging capacitor C, Fig. 3(b) being a diagram showing the phase characteristics due to the bridging capacitor C, and Fig. 3(c) being a plan view of a portion of an electrode forming the bridging capacitor C.

[Fig. 4] Figs. 4 are diagrams showing an aspect of the bridging capacitor in the first embodiment, where Fig. 4(a) being a diagram showing the amplitude characteristics of the transmission characteristics S21 and S31 due to the bridging capacitor C, Fig. 4(b) being a diagram showing the phase characteristics due to the bridging capacitor C, and Fig. 4(c) being a plan view of a portion of the electrode forming the bridging capacitor C.

[Fig. 5] Figs. 5 are diagrams showing an aspect of the bridging capacitor in the first embodiment, where Fig. 5(a) being a diagram showing the amplitude characteristics of the transmission characteristics S21 and S31 due to the bridging capacitor C, Fig. 5(b) being a diagram showing the phase characteristics due to the bridging capacitor C, and Fig. 5(c) being a plan view of a portion of the electrode forming the bridging capacitor C.

[Fig. 6] Fig. 6 is a plan view showing an electrode pattern configuration of a second embodiment of a SAW filter according to the present invention, showing only a lower half of the configuration.

[Fig. 7] Fig. 7 is a plan view showing an electrode pattern configuration of a third embodiment of a SAW filter according to the present invention.

[Fig. 8] Fig. 8 is a plan view showing an electrode pattern configuration of a fourth embodiment of a SAW filter according to the present invention.

[Fig. 9] Fig. 9 is a diagram showing the filter characteristics of the third and the fourth embodiments of the present invention.

[Fig. 10] Fig. 10 is a plan view showing an electrode pattern configuration of a fifth embodiment of a SAW filter according to the present invention.

[Fig. 11] Fig. 11 is a plan view showing an electrode pattern configuration of a sixth embodiment of a SAW filter according to the present invention.

[Fig. 12] Fig. 12 is a plan view showing an electrode pattern configuration of a seventh embodiment of a SAW filter according to the present invention.

[Fig. 13] Figs. 13 are diagrams showing an eighth embodiment of a SAW filter according to the present invention, where Fig. 13(a) being a plan view showing an electrode pattern configuration and Fig. 13 (b) being a diagram showing the filter characteristics.

[Fig. 14] Figs. 14 are diagrams showing a ninth embodiment of a SAW filter according to the present invention, where Fig. 14(a) being a plan view showing an electrode pattern configuration and Fig. 14 (b) being a diagram showing the filter characteristics.

[Fig. 15] Fig. 15 is a plan view showing a conventional unbalanced-balanced primary-tertiary double-mode SAW filter of a two-stage cascade-connection.

[Fig. 16] Fig. 16 is a cross section showing a configuration of a conventional SAW filter.

[Fig. 17] Fig. 17 is a diagram showing the configuration of the conventional SAW filter.

EXPLANATION OF THE CODES

| 1 | Piezoelectric substrate |
| 2, 6, 10, 14, 17 | Electrodes for capacitor formation |
| 3, 3', 4, 5, 9, 9', 11, 12, 13, 15 | Lead electrode |
| 7, 8 | IDT |
| F1, F2, F3 | Cascade-coupled primary-tertiary double-mode SAW filter |

**Claims**

1. A balanced surface acoustic wave filter in which an input side formed on a piezoelectric substrate is made to be unbalanced and an output side formed thereon is made to be balanced, wherein
an output pad electrode disposed farther away from an input pad electrode disposed on said piezoelectric substrate is coupled via a bridging capacitor.

2. A balanced surface acoustic wave filter of a cascade-coupled double-mode in which three interdigital transducers are arranged in proximity on a piezoelectric substrate along a propagation direction of a surface acoustic wave and reflectors are arranged on both sides of the interdigital transducers, and an input side is made to be unbalanced and an output side is made to be balanced, wherein
an output pad electrode disposed farther away from an input pad electrode disposed on said piezoelectric substrate is coupled via a bridging capacitor.

3. A balanced surface acoustic wave filter in which two cascade-coupled double-mode surface acoustic wave filters having a configuration where three interdigital transducers are arranged in proximity on a piezoelectric substrate along a propagation direction of a surface acoustic wave and reflectors are arranged on both sides of the interdigital transducers are cascade-connected, and an input side is made to be unbalanced and an output side is made to be balanced, wherein
an output pad electrode disposed farther away from an input pad electrode disposed on said piezoelectric substrate is coupled via a bridging capacitor.

4. A balanced acoustic wave filter in which cascade-coupled double-mode surface acoustic wave filters having a configuration where three interdigital transducers are arranged in proximity on a piezoelectric substrate along a propagation direction of a surface acoustic wave and reflectors are arranged on both sides of the interdigital transducers are arranged in parallel through a predetermined space, electrodes of the interdigital transducers of said cascade-coupled double-mode surface acoustic wave filters disposed at both outsides, the electrodes being disposed at the side of the space, are connected to each other and outside electrodes thereof are connected to ground pad electrodes, an electrode of the interdigital transducer of one of said cascade-coupled double-mode surface acoustic wave filters disposed at a central portion, the electrode being disposed at the side of the space, is connected to a ground pad electrode and an outside electrode thereof is connected to an input pad electrode, and an electrode of the interdigital transducer of the other of said cascade-coupled double-mode surface acoustic wave filters disposed at a central portion, the electrode being disposed at the side of the space, is connected to a first output pad electrode and an outside electrode thereof is connected to a second output pad electrode, where an input side is made to be unbalanced and an output side is made to be balanced, wherein
said input pad electrode and said second output pad electrode are coupled to each other via a bridging capacitor disposed on said piezoelectric substrate.

5.   The balanced surface acoustic wave filter according to claim 4, wherein a lead electrode connecting said bridging capacitor is provided on a peripheral edge of said piezoelectric substrate.

6.   The balanced surface acoustic wave filter according to claim 4, wherein a lead electrode connecting said bridging capacitor is provided on one peripheral edge of said piezoelectric substrate.

7.   The balanced surface acoustic wave filter according to claim 4, wherein said capacitor is configured by arranging a lead electrode from said input pad electrode to a central portion of the piezoelectric substrate along a peripheral edge of said piezoelectric substrate and arranging a lead electrode from said second output pad electrode to the central portion of said piezoelectric substrate along the peripheral edge of said piezoelectric substrate.

8.   A balanced surface acoustic wave filter in which a cascade-coupled double-mode surface acoustic wave filter is configured by arranging three interdigital transducers on a piezoelectric substrate in proximity along a propagation direction of a surface acoustic wave and arranging reflectors on both sides of the interdigital transducers, respective ones of electrodes of the interdigital transducers of said cascade-coupled double-mode surface acoustic wave filter arranged at both outsides thereof are connected to input pad electrodes, and the other electrodes thereof are grounded, respectively, and one of electrodes of the interdigital transducer arranged at a central portion thereof is connected to a first output pad electrode and the other electrode thereof is connected to a second output pad electrode, where an input side is made to be unbalanced and an output side is made to be balanced, wherein
said input pad electrode and said second output pad electrode are coupled to each other via a bridging capacitor disposed on said piezoelectric substrate.

9.   The balanced surface acoustic wave filter according to claim 8, configured by arranging a first electrode near the surroundings of said second output pad electrode, providing a second electrode near a lead electrode connecting said input pad electrode and one of the interdigital transducers of said cascade-coupled double-mode surface acoustic wave filter disposed outside, and connecting said first and said second electrodes through a lead electrode.

[Fig.1]

[Fig.2]

[Fig.3]

(a)

(b)

(c)

[Fig.4]

(a)

(b)

(c)

[Fig.5]

(a)

(b)

(c)

[Fig.6]

[Fig.7]

[Fig.8]

[Fig.9]

[Fig.10]

[Fig.11]

[Fig.12]

[Fig.13]

(a)

(b)

[Fig.14]

(a)

(b)

[Fig.15]

IN

55a  53  52  54  55b

F1

51

F2

55'a  53'  52'  54'  55'b

OUT1  OUT2

[Fig.16]

64  61

68

63  67  66  62  67  62  65

66

[Fig.17]

(a)

(b)

(c)

(d)

(e)

(f)

**EP 1 737 126 A1**

**INTERNATIONAL SEARCH REPORT**

| International application No. |
| --- |
| PCT/JP2005/007089 |

A. CLASSIFICATION OF SUBJECT MATTER
Int.Cl$^7$ H03H9/64, H01L41/09, 41/18, H03H9/145

According to International Patent Classification (IPC) or to both national classification and IPC

B. FIELDS SEARCHED

Minimum documentation searched (classification system followed by classification symbols)
Int.Cl$^7$ H03H9/64, H01L41/09, 41/18, H03H9/145

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>A | JP 2003-60484 A (Murata Mfg. Co., Ltd.),<br>28 February, 2003 (28.02.03),<br>Full text; Figs. 1, 2<br>& US 2003/0035557 A1 & CN 1402582 A<br>& KR 2003015148 A | 1-3<br>4-9 |
| A | JP 2000-312125 A (Kyocera Corp.),<br>07 November, 2000 (07.11.00),<br>Full text; all drawings<br>(Family: none) | 1-9 |
| A | JP 2003-218670 A (Matsushita Electric<br>Industrial Co., Ltd.),<br>31 July, 2003 (31.07.03),<br>Full text; all drawings<br>& EP 1263137 A2 & US 2003/0001695 A1<br>& CN 1389982 A | 1-9 |

[X] Further documents are listed in the continuation of Box C.     [ ] See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>12 July, 2005 (12.07.05) | Date of mailing of the international search report<br>26 July, 2005 (26.07.05) |
| --- | --- |
| Name and mailing address of the ISA/<br>Japanese Patent Office | Authorized officer |
| Facsimile No. | Telephone No. |

Form PCT/ISA/210 (second sheet) (January 2004)

25

**INTERNATIONAL SEARCH REPORT**

| International application No. |
|---|
| PCT/JP2005/007089 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-204243 A (Matsushita Electric Industrial Co., Ltd.), 18 July, 2003 (18.07.03), Full text; Fig. 7 & EP 1315297 A2 & US 2003/0107454 A1 & CN 1418031 A & KR 2003035991 A | 8-9 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002076828 A

- JP 3440935 B